# EUROPEAN PATENT APPLICATION

(11) **EP 4 212 590 A1**
(43) Date of publication of application: **19.07.2023**
(21) Application number: 21864476.3
(22) Date of filing: 07.09.2021
(51) Int. Cl.: C08L 101/00, C08K 3/10, H05K 9/00

(54) **THERMOPLASTIC RESIN COMPOSITION HAVING ELECTROMAGNETIC SHIELDING PROPERTIES, AND MOLDED COMPONENT**

(30) Priority: 07.09.2020 JP 2020149956
(71) Applicant: Denka Company Limited, Tokyo 103-8338 (JP)
(72) Inventor: MIYAMA, Akira, Tokyo 103-8338 (JP); MASHIKO, Yoshihiro, Tokyo 103-8338 (JP)
(74) Representative: Gulde & Partner
(86) International application number: PCT/JP2021/032862
(87) International publication number: WO 2022/050425

(57) **Abstract**

An object of the present invention is to provide a soft magnetic powder-containing resin composition capable of undergoing heating and melt-mold processing and having superior shielding performance (masking performance) with respect to low frequency region electromagnetic waves of 1 MHz or lower, and a molded article of the composition. A thermoplastic resin composition, including: a thermoplastic resin; and 20 to 80 volume^ of soft magnetic powder containing an alloy represented by a compositional formula of FeₐB_{b}Si_{c}PₓC_{y}Cu_{z}; wherein: 79 ≤ a ≤ 86 atomic%, 5 ≤ b ≤ 13 atomic^, 0 < c ≤ 8 atomic%, 1 ≤ x ≤ 8 atomic^, 0 < y ≤ 5 atomic%, 0.4 ≤ z ≤ 1.4 atomic%, and 0.08 ≤ z/x ≤ 0.8 are satisfied, is provided.

## Description

### TECHNICAL FIELD

The present invention relates to a soft magnetic powder-containing resin composition formulated with soft magnetic powder, the soft magnetic powder having a shielding performance to shield electromagnetic waves in low frequency region. The shielding performance suppresses electromagnetic wave noise by shielding or absorbing electromagnetic waves having a frequency of 1 MHz or lower (hereinafter frequently referred to as low frequency region electromagnetic waves) which is generated inside various electronic equipment, especially from power conversion equipment and data processing equipment installed in electrically driven vehicles. The present invention also relates to molded articles such as sheet, hose and the like made from the soft magnetic powder-containing resin composition.

### BACKGROUND

The unnecessary electromagnetic waves generated from various electronic equipment influence other electronic equipment and thus cause malfunction. In order to suppress such unfavorable effects of the unnecessary electromagnetic waves, electromagnetic wave shielding material is used.

As such electromagnetic wave shielding material, various soft magnetic materials have been suggested. Regarding such soft magnetic material, permalloy materials are generally known to show superior shielding performance with respect to electromagnetic waves having a frequency of several hundred MHz to several GHz.

As one example of the soft magnetic material, a nanocrystalline soft magnetic material containing rare earth elements (such as Nb) as an essential component having crystallized Fe-base portion is known. Such is studied as an electromagnetic waves shielding material in high frequency of 1 GHz or more.

Recently, Fe-base nanocrystalline soft magnetic material which does not contain the rare earth elements and is structured only with general purpose element, that is, a novel nanocrystalline soft magnetic material described hereinafter has been suggested. This material is an alloy composition having a compositional formula of FeₐB_{b}Si_{c}PₓC_{y}Cu_{z}. Here, the subscripts of a, b, c, x, y, and z represent values which satisfy 79 ≤ a ≤ 86 atomic%, 5 ≤ b ≤ 13 atomic%, 0 < c ≤ 8 atomic%, 1 ≤ x ≤ 8 atomic%, 0 < y ≤ 5 atomic%, 0.4 ≤ z ≤ 1.4 atomic%, and 0.08 ≤ z/x ≤ 0.8. In addition, this material can be obtained melting the raw material using high frequency induction melting apparatus and the like, followed by rapidly cooling the molten alloy composition by single-roll liquid quenching method to form a continuous thin strip. Subsequently, the continuous thin strip is subjected to heat treatment under temperature retaining conditions of 450 to 550 °C x 10 min and temperature raising conditions of 60 to 1200 °C/min, thereby obtaining a thin strip shape having nanocrystalline alloy structure in which the Fe-base portion is highly crystallized.

As the molded form of the electromagnetic wave shielding material, sheet, laminated sheet, hose, shielding case and the like have been suggested and are utilized.

### CITATION LIST

### PATENT LITERATURE

[Patent Literature 1] JP H4-4393B
[Patent Literature 2] JP H11-298187A
[Patent Literature 3] JP 4195400B
[Patent Literature 4] JP 4557301B
[Patent Literature 5] JP 4514828B
[Patent Literature 6] JP 2017-510993A
[Patent Literature 7] JP 4362403B
[Patent Literature 8] JP H5-145271A
[Patent Literature 9] JP H4-133446A Utility Patent

### SUMMARY OF INVENTION

### TECHNICAL PROBLEM

However, in the past, conventional soft magnetic material have been processed into thick plate, laminated, and used as a casing to surround the object to sufficiently shield the low frequency region electromagnetic waves having a frequency of 1 MHz or lower. However, these measures were problematic since the shielded portion would become excessively heavy. In order to achieve current needs in lighter, thinner, and smaller electronic equipment and lighter electrically driven vehicles, thermoplastic resin composition capable of undergoing melt-mold processing to comply with thin and complicated shapes of components has been desired.

That is, an object of the present invention is to provide a soft magnetic powder-containing resin composition capable of undergoing heating and melt-mold processing and having superior shielding performance (masking performance) with respect to low frequency region electromagnetic waves of 1 MHz or lower, and a molded article of the composition.

### SOLUTION TO PROBLEM

According to the present invention, a thermoplastic resin composition, comprising: a thermoplastic resin; and 20 to 80 volume^ of soft magnetic powder containing an alloy represented by a compositional formula of FeₐB_{b}Si_{c}PₓC_{y}Cu_{z}; wherein: 79 ≤ a ≤ 86 atomic^, 5 ≤ b ≤ 13 atomic%, 0 < c ≤ 8 atomic^, 1 ≤ x ≤ 8 atomic%, 0 < y ≤ 5 atomic%, 0.4 ≤ z ≤ 1.4 atomic%, and 0.08 ≤ z/x ≤ 0.8 are satisfied, is provided.

The resin composition having electromagnetic waves shielding performance in the low frequency region, the resin composition being a thermoplastic resin formulated with a soft magnetic powder having the nanocrystalline alloy structure can be obtained by performing melt-kneading using known internal mixers and extruders within a suitable temperature range which allows the thermoplastic resin to be heated and melt. In addition, by using suitable dice and mold, the melt-kneaded material can be molded into sheet, hose, and other shapes.

Hereinafter, various embodiments of the present invention will be exemplified. The embodiments shown hereinafter can be combined with each other.

Preferably, the thermoplastic resin contains at least one selected from the group consisting of: polyethylene, polypropylene, polystyrene, ABS resin, polyvinyl chloride, polyvinylidene chloride, ethylene-vinyl acetate resin, polyurethane, acrylic resin, polycarbonate, polyamide, polyimide, polyphenylene sulfide, polyvinylidene fluoride, polytetrafluoroethylene, and polybutylene terephthalate.

Preferably, an attenuation factor of a magnetic field component measured at frequency of 0.3 MHz and 1 MHz are both 3 dB or more, the attenuation factor of the magnetic field component being measured in accordance with KEC method by using a 1.0 mm thick sheet of the thermoplastic resin composition.

According to another aspect of the present invention, a molded component obtained by heating and melt-mold processing the thermoplastic resin composition is provided.

### EFFECT OF THE INVENTION

According to the present invention, by formulating thermoplastic resin with a particular soft magnetic powder, a composition having superior electromagnetic waves shielding performance with respect to low frequency region electromagnetic waves and is capable of undergoing molding processing can be provided. In addition, a molded component of the composition such as sheet and hose can be provided.

### EMBODIMENTS OF THE INVENTION

Hereinafter, embodiment for carrying out the present invention will be explained in detail. Here, the embodiments explained hereinafter are only one typical embodiment of the present invention, and thus the scope of the invention shall not be interpreted narrowly.

The thermoplastic resin composition according to one embodiment of the present invention comprises soft magnetic powder and thermoplastic resin.

The soft magnetic powder of the present invention is a soft magnetic powder containing alloy having a compositional formula of FeₐB_{b}Si_{c}PₓC_{y}Cu_{z}. The alloy is an alloy composition having nanocrystalline alloy structure in which the Fe-base portion is highly crystallized. The soft magnetic powder preferably contains the alloy as main component. The soft magnetic powder preferably contains the alloy by 50 mass% or more, and more preferably contains the alloy by 90 mass% or more, and further preferably consists essentially of the alloy.

The subscripts of a, b, c, x, y, and z in the compositional formula represent values which satisfy 79 ≤ a ≤ 86 atomic%, 5 ≤ b ≤ 13 atomic%, 0 < c ≤ 8 atomic%, 1 ≤ x ≤ 8 atomic%, 0 < y ≤ 5 atomic%, 0.4 ≤ z ≤ 1.4 atomic%, and 0.08 ≤ z/x ≤ 0.8. In addition, the soft magnetic powder can be obtained, for example, by the method disclosed in the cited Patent Literature 5. Alloy is subjected to rapid cooling from a molten state, followed by raising the temperature under a certain condition to obtain a thin strip having a nanocrystalline alloy structure in which the Fe-base portion is highly crystallized. The thin strip is used as the raw material and subjected to pulverization by known pulverization method to give the soft magnetic powder. As the pulverization method, dry pulverization method and wet pulverization method can be mentioned for example. In terms of productivity and maintaining magnetic characteristics of the pulverized powder, pulverization methods such as cyclone mill, mixer mill, planetary ball mill, and jet mill are preferably used. In addition, known screening procedure and classification method can be adopted to obtain the soft magnetic powder in a certain particle size range. As the thin strip, NANOMET (product name) available from Tohoku Magnet Institute can be mentioned.

The shape of the soft magnetic powder can be any one of spherical, flat, and irregular, and similar shielding effect can be realized. The soft magnetic powder has a maximum diameter of 500 um, more preferably 100 um, which can be obtained by known screening procedure. Here, the maximum diameter of the powder is the maximum diameter of each particle when the shape of the powder is irregular or flat. When the maximum diameter exceeds 500 um, the electromagnetic waves shielding performance may become ununiform within the molded object, or a defective portion may occur.

The soft magnetic powder-containing resin composition contains the soft magnetic powder by 20 volume% to 80 volume%, more preferably by 30 volume% to 70 volume%. When the content of the soft magnetic powder is less than 20 volume%, sufficient electromagnetic waves shielding performance would not be realized, and when the content exceeds 80 volumeo, flowability during kneading or molding becomes insufficient, resulting in cases where desired shape cannot be molded. In addition, the kneaded product would become brittle, which is undesirable. Here, other soft magnetic powder can be added by a small amount so long as it does not impair the effect of the present invention. The content of the soft magnetic powder in the soft magnetic powder-containing resin composition is, specifically for example, 20, 25, 30, 35, 40, 45, 50, 55, 60, 65, 70, 75, or 80 volume%, and can be in the range between the two values exemplified herein. Here, in the present specification, the wave dash symbol "-" is a symbol used to show that the numerical values presented before and after the symbol is included in the numerical range. Specifically, the description of "X ~ Y" ("X to Y", both X and Y represent numerical value) means "X or more and Y or less".

The thermoplastic resin is, for example, at least one selected among polyethylene (PE), polypropylene (PP), polystyrene (PS), ABS resin, polyvinyl chloride (PVC), polyvinylidene chloride (PVDC), ethylene-vinyl acetate resin (EVA), polyurethane (PU), acrylic resin (PMMA), polycarbonate (PC), polyamide (PA), polyimide (PI), polyphenylene sulfide (PPS), polyvinylidene fluoride (PVDF), polytetrafluoroethylene (PTFE), polybutylene terephthalate (PBT), and the like. In terms of the ability to disperse the soft magnetic powder and to obtain uniform electromagnetic waves shielding performance, ABS resin, polyvinyl chloride, ethylene-vinyl acetate resin and the like may be preferable as the thermoplastic resin.

So long as it does not significantly impair the electromagnetic waves shielding performance in the low frequency region, processing auxiliary and various compounding agent can be added. When the processing auxiliary is added, the processing auxiliary is added preferably by 0.1 mass% to 1 mass, more preferably 0.3 to 0.5 mass% with respect to total sum of the thermoplastic resin and the soft magnetic powder. As the processing auxiliary, polyethylene glycol fatty acid ester and the like can be mentioned.

As the kneading method, known melt-kneader such as internal mixer and extruder can be used. As the kneading temperature and the kneading time, suitable known conditions for kneading and molding can be selected for each of the thermoplastic resin. To improve dispersibility of the soft magnetic powder, it is preferable to adopt high-speed rotation conditions and high-shear conditions to an extent that notable deterioration of thermoplastic resin and fragmentation of soft magnetic powder does not occur. Further, kneading of the soft magnetic powder can be performed by adding the soft magnetic powder with the thermoplastic resin simultaneously, or the soft magnetic powder can be added after heating and melting the thermoplastic resin or during heating and melting the thermoplastic resin (later addition). The order of addition can be arbitrarily selected in terms of improvement in dispersibility and suppression in resin deterioration.

The thermoplastic resin composition formulated with the soft magnetic powder thus obtained (molding raw material) is molded into a desired shape by using hot press or melt extruder, with suitable dice or mold. As such shape, sheet, hose, and case-shape can be mentioned for example. The molding raw material can be molded into various shapes by selecting the mold. In addition, laminated sheet can be made by using a plurality of extruders, and laminate sheet with a plurality of layers can be made by using adhesive and the like.

The molded article can be a molded member used for shielding low frequency region electromagnetic waves of various equipment. In one example, the molded article is processed into sheet as described above. Here, when the sheet is structured with a plurality of layers, the shielding effect may be enhanced even with the same thickness. In one embodiment of the present invention, high shielding effect can be expected when the sheet is structured with a plurality of layers, also. On the other hand, in the present invention, even with an embodiment in which the sheet and the like are structured with single layer, sufficient shielding effect can be achieved.

As a method for evaluating the electromagnetic wave noise shielding performance (blocking performance), KEC method developed by general foundational juridical person KEC Electronic Industry Development Center (KEC) is known. For example, this method is described in Journal of the Japan Research Association for textile end-uses (Sen-sho-shi) Vol. 40, No.2 (1999) and "https://www.kec.jp/testing-division/kec-method/". The KEC method is a method which measures the shielding effect of the electromagnetic waves generated in the near field separated into electric field component and magnetic field component. The electromagnetic waves transmitted from the transmitting antenna (transmitting jig) is received with the receiving antenna (receiving jig) via a sheet-shaped measurement sample, and the attenuated electromagnetic waves are measured to perform quantification as attenuation factor (measurement unit: dB). In the present invention, under room temperature conditions, sample with uniform thickness (2.0 mm) was used to measure the attenuation factor of the magnetic field component in the frequency range of 0.1 MHz to 1000 MHz. Here, the electromagnetic waves shielding performance (magnetic field component) with respect to frequency in the range of 1 MHz or lower, which is important in the present invention, was evaluated by comparing the measured attenuation factors for 0.3 MHz and 1 MHz.

Regarding the attenuation factor of the thermoplastic resin composition, the attenuation factor of the magnetic field component measured at frequency of 0.3 MHz and 1 MHz are both preferably 3 dB or more. Here, the attenuation factor of the magnetic field component is measured in accordance with KEC method by using a 1.0 mm sheet obtained by molding the thermoplastic resin composition (and represents the attenuation factor of the magnetic field component of electromagnetic waves measured in accordance with KEC method with respect to electromagnetic waves having a frequency of 0.3 MHz and 1 MHz using a 1.0 mm sheet obtained by molding the thermoplastic resin composition). The composition has superior shielding performance with respect to electromagnetic waves in the low frequency region of 1 MHz or lower.

### EXAMPLE

### [Examples 1 to 7]

Hereinafter, the effect of the present invention will be explained with reference to Examples and Comparative Examples of the present invention. In accordance with the compositions shown in Table 1, resin composition formulated with the soft magnetic powder was prepared. As the soft magnetic powder, NANOMET thin strip pulverized powder (average particle diameter of 30 µ, maximum particle diameter of 100 p, specific gravity of 7.3) obtained by pulverizing NANOMET thin strip (width of 126 mm, thickness of 25 µ) available from Tohoku Magnet Institute with known method was used. Hereinafter, the pulverized powder will be referred to as NANOMET pulverized powder. As the thermoplastic resin, EVA resin (available from Tosoh Corporation, EVA resin U-636, specific gravity of 0.94) was used. Here, in Examples 5 to 7, polyethylene glycol fatty acid ester (available from Kao Corporation, EMANON 1112) as the processing auxiliary was added by 0.1 weight% with respect to total weight of the EVA resin and NANOMET pulverized powder. As the kneading machine, Labo Plastomill available from Toyo Seiki Seisaku-sho, Ltd. (60 mL capacity) was used. EVA resin and the soft magnetic powder of the present invention were charged into the kneading machine at the same time by the charging composition shown in Table 1. Kneading was performed by a rotation number of 50 rpm at 130 °C for 10 minutes to obtain the resin composition formulated with the soft magnetic powder (hereinafter simply referred to as composition). The composition was then melt-molded using a hot press set at 150 °C and a sheet mold having a thickness of 1 mm, thereby preparing a square molded sheet of 150 mm x 150 mm in length and width and 1.0 mm thickness. The electromagnetic waves shielding performance (magnetic field component) of the 1.0 mm molded sheet of the Example was measured at "general foundational juridical person KEC Electronic Industry Development Center (Seika-cho, Soraku District, Kyoto Prefecture)". The values were obtained by using the apparatus shown in Fig. 7 and sandwiching the molded sheet with a pair of magnetic field shielding effect evaluation cell (Fig. 6) as shown in "Journal of the Japan Research Association for textile end-uses (Sen-sho-shi) Vol. 40, No.2 (1999)" at the Center. Here, the applied frequency during the measurement was gradually increased ranging from 0.1 MHz to 1000 MHz. The attenuation factor (relative value) calculated from the transmitting/receiving strength value at 0.3 MHz and 1 MHz were used as the values which represent the magnetic field shielding effect of the present invention. The results are shown in Table 1. All of the sheets obtained from the composition of the present invention showed attenuation factor of 3 dB or more at frequency of 0.3 MHz and 1 MHz. Accordingly, the sheets had meaningful electromagnetic waves shielding performance. In addition, when the formulation amount of NANOMET pulverized powder was increased from 20 volume% to 80 volume%, the attenuation factor was improved. In particular, when the formulation amount was 40 volume^ or more, the attenuation factor was 5 dB or more. The electromagnetic waves (magnetic field component) shielding performance is further clear.

**[Table 1]**

| | Example | | | | | | |
|---|---|---|---|---|---|---|---|
| | 1 | 2 | 3 | 4 | 5 | 6 | 7 |
| EVA resin (volume%) | 80 | 70 | 60 | 50 | 40 | 30 | 20 |
| NANOMET pulverized powder (volume%) | 20 | 30 | 40 | 50 | 60 | 70 | 80 |
| polyethylene glycol fatty acid ester (weieht%) | - | - | - | - | 0.1 | 0.1 | 0.1 |
| kneading machine | Labo Plastomill | Labo Plastomill | Labo Plastomill | Labo Plastomill | Labo Plastomill | Labo Plastomill | Labo Plastomill |
| sheet thickness | 1mm | 1mm | 1mm | 1mm | 1mm | 1mm | 1mm |
| [electromagnetic wave shielding performance (magnetic field)] KEC method (magnetic field) measurement value | | | | | | | |
| attenuation factor at 0.3 MHz [dB] | 3.1 | 4.3 | 5.5 | 6.9 | 9.0 | 11.2 | 14.0 |
| attenuation factor at 1 MHz [dB] | 3.4 | 4.7 | 6.3 | 7.8 | 10.1 | 12.6 | 15.6 |

### [Examples 8 to 10]

A single-screw extruder with kneading mechanism having a barrel diameter of 30 mm and L/D=16 was used. A T-die having a slit of 0.7 mm and a width of 150 mm was attached at the tip portion. The temperature of the barrel was set to 80 to 150 °C, and the rotation number was 40 rpm. A predetermined amount of EVA resin, processing auxiliary (polyethylene glycol fatty acid ester), and soft magnetic powder were charged, thereby obtaining a sheet-shaped molded object of the resin composition formulated with the soft magnetic powder. Subsequently, the sheet-shaped molded object was further subjected to press molding using a hot press set at 150 °C and a sheet mold having 1 mm thickness to make slight adjustments to the thickness of the molded sheet. Accordingly, a molded sheet having a thickness of 1.0 mm was finally obtained. The results obtained by measuring the electromagnetic waves shielding performance (magnetic field component) of the 1.0 mm thick molded sheet in a similar manner as Example 1 are shown in Table 2. From Table 2, it can be understood that all of the Examples showed attenuation factors of 4 dB or more for frequency of 0.3 MHz and 1 MHz.

**[Table 2]**

| | Example | | |
|---|---|---|---|
| | 8 | 9 | 10 |
| EVA resin (volume%) | 70 | 60 | 50 |
| NANOMET pulverized powder (volume%) | 30 | 40 | 50 |
| polyethylene glycol fatty acid ester (weight%) | 0.3 | 0.5 | 0.5 |
| kneading machine | single-screw extruder | single-screw extruder | single-screw extruder |
| molded shape after extrusion | sheet | sheet | sheet |
| thickness | 1mm | 1mm | 1mm |
| [electromagnetic wave shielding performance (magnetic field)] KEC method (magnetic field) measurement value | | | |
| attenuation factor at 0.3 MHz [dB] | 4.1 | 5.3 | 6.6 |
| attenuation factor at 1 MHz [dB] | 4.7 | 6.3 | 7.8 |

### [Comparative Examples 1 to 3]

In Comparative Example 1, the NANOMET pulverized powder of the present invention was not formulated. The attenuation factor was approximately 0.1 to 0.3 dB, and electromagnetic waves shielding performance was scarcely realized. In Comparative Example 2, the formulation amount of the NANOMET pulverized powder was 10 volume%. The attenuation factor at 0.3 MHz was 1.6 dB, showing little electromagnetic waves shielding performance. Therefore, it cannot be said that electromagnetic waves shielding performance was sufficiently realized. In Comparative Example 3, the formulation amount of the NANOMET pulverized powder was 90 volume%. The molded object was extremely brittle, and thus was not able to maintain the sheet form to perform measurement under KEC method. In Comparative Example 4, soft ferrite powder (BSN-714 available from TODA KOGYO CORP., specific gravity of 5.3, average particle diameter of 6 µ) was formulated as the soft magnetic powder by 50 volume%. In Comparative Example 5, permalloy C powder (DAPPC (78Ni-4Mo-Fe) available from Daido Steel Co., Ltd., specific gravity of 8.8, average particle diameter of 9 µ)was formulated as the soft magnetic powder by 50 volume%. It can be understood that all of them showed attenuation factors of lower than 3.0 at 0.3 MHz and 1 MHz. From these results, it is apparent that the composition formulated with the NANOMET pulverized powder of the present invention has superior electromagnetic waves shielding performance in the low frequency region of 1 MHz or lower. In addition, the composition can undergo melt-mold processing to manufacture molded components.

**[Table 3]**

| | Comparative Example | | | | |
|---|---|---|---|---|---|
| | 1 | 2 | 3 | 4 | 5 |
| EVA resin (volume%) | 100 | 90 | 10 | 50 | 50 |
| NANOMET pulverized powder (volume%) | - | 10 | 90 | - | - |
| ferrite powser (volume%) | - | - | - | 50 | - |
| permalloy C powder (volume%) | - | - | - | - | 50 |
| kneading machine | Labo Plastomill | Labo Plastomill | Labo Plastomill | Labo Plastomill | Labo Plastomill |
| sheet thickness | 1mm | 1mm | sheet not obtained | 1mm | 1mm |
| [electromagnetic wave shielding performance (magnetic field)] KEC method (magnetic field) measurement value | | | | | |
| attenuation factor at 0.3 MHz [dB] | 0.1 | 1.6 | - | 0.5 | 0.3 |
| attenuation factor at 1 MHz [dB] | 0.2 | 2.1 | - | 1.6 | 1.9 |

### INDUSTRIAL APPLICABILITY

The thermoplastic resin composition formulated with the soft magnetic powder of the present invention has superior shielding performance with respect to low frequency region electromagnetic wave noise having a frequency of 1 MHz or lower and is thus extremely industrially useful. In addition, the thermoplastic resin composition is capable of undergoing heating and melt-molding, and is suitable as a molded component to shield electromagnetic wave noise in the low frequency region which is generated inside various electronic equipment, and power conversion equipment and data processing equipment installed in electrically driven vehicles.

## Claims

1. A thermoplastic resin composition, comprising:
a thermoplastic resin; and
20 to 80 volume% of soft magnetic powder containing an alloy represented by a compositional formula of FeₐB_{b}Si_{c}PₓC_{y}Cu_{z}; wherein:
79 ≤ a ≤ 86 atomic%, 5 ≤ b ≤ 13 atomic%, 0 < c ≤ 8 atomic%, 1 ≤ x ≤ 8 atomic%, 0 < y ≤ 5 atomic%, 0.4 ≤ z ≤ 1.4 atomic%, and 0.08 ≤ z/x ≤ 0.8 are satisfied.

2. The thermoplastic resin composition of Claim 1, wherein the thermoplastic resin contains at least one selected from the group consisting of: polyethylene, polypropylene, polystyrene, ABS resin, polyvinyl chloride, polyvinylidene chloride, ethylene-vinyl acetate resin, polyurethane, acrylic resin, polycarbonate, polyamide, polyimide, polyphenylene sulfide, polyvinylidene fluoride, polytetrafluoroethylene, and polybutylene terephthalate.

3. The thermoplastic resin composition of Claim 1 or 2, wherein an attenuation factor of a magnetic field component measured at frequency of 0.3 MHz and 1 MHz are both 3 dB or more, the attenuation factor of the magnetic field component being measured in accordance with KEC method by using a 1.0 mm thick sheet of the thermoplastic resin composition.

4. A molded component obtained by heating and melt-mold processing the thermoplastic resin composition of Claim 3.
